Europäisches Patentamt

European Patent Office

Office européen des brevets

(19)

(11) Veröffentlichungsnummer: **0 011 094**
**B1**

(12) ## EUROPÄISCHE PATENTSCHRIFT

(45) Veröffentlichungstag der Patentschrift:
21.04.82

(51) Int. Cl.³: **G 01 R 21/00, G 01 R 21/06**

(21) Anmeldenummer: 79103030.7

(22) Anmeldetag: 20.08.79

(54) Einrichtung zur Messung elektrischer Leistung.

(30) Priorität: 13.11.78 CH 11634/78

(43) Veröffentlichungstag der Anmeldung:
28.05.80 Patentblatt 80/11

(45) Bekanntmachung des Hinweises auf die Patenterteilung:
21.04.82 Patentblatt 82/16

(84) Benannte Vertragsstaaten:
DE FR GB IT NL SE

(56) Entgegenhaltungen:
DE-A-2 714 632
GB-A-1 373 581
US-A-3 778 608
ALTA FREQUENZA, Band 35, Nr. 11, November 1966,
G. SACERDOTI et. al.: »A standard digital energy meter for measurements in single-phase circuits and of active and reactive energy in symmetrical three-phase circuits«,
Seiten 889—898

(73) Patentinhaber: LGZ LANDIS & GYR ZUG AG,
Konzern-Patentabteilung, CH-6301 Zug (CH)

(72) Erfinder: Schneider, Gernot, Arbach 55a, CH-6340 Baar (CH)
Erfinder: Steinle, Benedikt, Schönbühl 10, CH-6300 Zug (CH)

(74) Vertreter: Müller, Hans-Jürgen, Dipl.-Ing.,
Postfach 801369, D-8000 München 80 (DE)

## Einrichtung zur Messung elektrischer Leistung

Die Erfindung bezieht sich auf eine Einrichtung zur Messung elektrischer Leistung in einem Wechselstromnetz der im Oberbegriff des Anspruchs 1 genannten Art.

Eine solche Meßeinrichtung ist aus Alta Frequenza, Vol. XXXV, Nr. 11, Nov. 1966, Seiten 889 bis 898, bekannt. Dort werden die ermittelten digitalen Spannungs-Meßwerte und Strom-Meßwerte unmittelbar miteinander multipliziert. Einflüsse verschiedenster Art können dazu führen, daß die digitalen Spannungs- und Strom-Meßwerte mit einem Nullpunktfehler behaftet sind, was sich auf das Produkt der Multiplikation auswirkt und einen entsprechenden Meßfehler verursacht.

Ferner ist eine Einrichtung zur Messung elektrischer Energie bekannt (CH-PS 538 122), bei der zwei von Modulatoren erzeugte Impulsfolgen in einem UND-Tor verknüpft und mit von einem Impulsgenerator erzeugten Abtastimpulsen abgetastet werden. Die mittlere Häufigkeit der so entstehenden Ausgangsimpulse ist ein Maß für die elektrische Leistung. Auch bei dieser Meßeinrichtung können Einflüsse verschiedenster Art dadurch einen Nullpunktfehler der Messung verursachen, daß die beiden von den Modulatoren erzeugten Impulsfolgen nicht genau symmetrisch sind, wenn die Spannung bzw. der Strom den Wert Null aufweist. Der durch solche Unsymmetrien hervorgerufene Nullpunktfehler der Messung kann zwar teilweise kompensiert werden, wenn das UND-Tor durch ein Exklusiv-ODER-Tor ersetzt wird. Diese Art der Kompensation von Symmetriefehlern der Modulatoren bedingt jedoch, daß die Produktbildung aus Spannung und Strom nach einer statistischen Koinzidenzmethode erfolgt, und kann bei Meßeinrichtungen mit digitaler Produktbildung nicht angewandt werden.

Der Erfindung liegt die Aufgabe zugrunde, eine Einrichtung zur Messung elektrischer Leistung in einem Wechselstromnetz der eingangs genannten Art zu schaffen, bei welcher der Einfluß von Symmetrie- bzw. Nullpunktfehlern der von den beiden Modulatoren erzeugten Impulsfolgen auf das Meßresultat weitestgehend vermindert ist.

Diese Aufgabe wird erfindungsgemäß durch die im Kennzeichen des Anspruchs 1 angegebenen Merkmale gelöst.

Das im Anspruch 1 angegebene Differenzglied liefert digitale Spannungs- bzw. Strom-Meßwerte, die entsprechend dem Mittelwert der Impulsdauer der aus der Spannung bzw. aus dem Strom gebildeten Impulsfolge korrigiert sind, so daß sich Symmetriefehler der beiden Impulsfolgen auf das Meßresultat kaum mehr auswirken können.

Nachfolgend wird ein Ausführungsbeispiel der Erfindung anhand der Zeichnung näher erläutert. Es zeigt

Fig. 1 ein Blockschaltbild und

Fig. 2 ein Spannungs-Zeit-Diagramm.

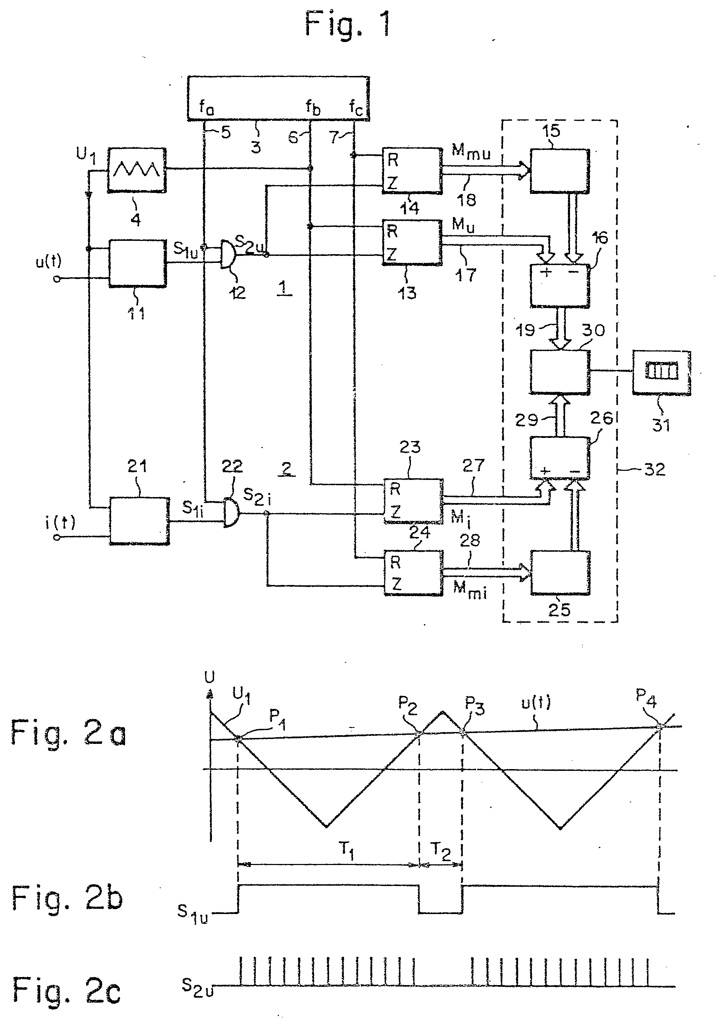

In der oberen Hälfte der Fig. 1 ist ein Spannungskanal 1 und in der unteren Hälfte ein Strommeßkanal 2 dargestellt. Ein Impulsgenerator 3 und ein von diesem gesteuerten Dreieckgenerator 4 sind beiden Meßkanälen 1, 2 gemeinsam. Der Meßkanal 1 besteht aus einem Komparator 11, einem UND-Tor 12, einem Impulszähler 13, einem als digitaler Mittelwertbilder wirkenden Impulszähler 14, einem Glättungsfilter 15 und einem digitalen Differenzglied 16. Der in gleicher Weise aufgebaute Meßkanal 2 enthält einen Komparator 21, ein UND-Tor 22, einen Impulszähler 23, einen als digitalen Mittelwertbilder arbeitenden Impulszähler 24, ein Glättungsfilter 25 und ein digitales Differenzglied 26. Ein der zu messenden Spannung proportionales elektrisches Signal $u(t)$ ist an einen ersten Eingang des Komparators 11 und ein dem zu messenden Strom proportionales elektrisches Signal $i(t)$ an einen ersten Eingang des Komparators 21 angelegt. Der Ausgang des Dreieckgenerators 4 ist jeweils mit dem zweiten Eingang der Komparatoren 11, 21 verbunden. Die Komparatoren 11, 21 arbeiten zusammen mit dem Dreieckgenerator 4 als sog. Mark-Space-Modulatoren zur Bildung einer Impulsfolge $S_{1u}$ bzw. $S_{1i}$, deren Impulsdauer ein Maß für den Momentanwert des Signals $u(t)$ bzw. $i(t)$ darstellt.

Der Impulsgenerator 3 besitzt drei Ausgänge 5, 6 und 7. Der Ausgang 5 liefert Abtastimpulse mit der Frequenz $f_a$, der Ausgang 6 Rückstellimpulse mit der Frequenz $f_b$ und der Ausgang 7 Rückstellimpulse mit der Frequenz $f_c$. Vorteilhaft weist der Impulsgenerator 3 einen quarzstabilisierten Oszillator mit der Frequenz $f_a$ auf, aus der die Frequenzen $f_b$ und $f_c$ durch Frequenzteilung gewonnen werden. Der Ausgang 5 ist mit dem an den Komparator 11 angeschlossenen UND-Tor 12 und mit dem an den Komparator 21 angeschlossenen UND-Tor 22, der Ausgang 6 mit je eine Rückstelleingang R der Impulszähler 13 und 23 und der Ausgang 7 mit je einem Rückstelleingang R der Impulszähler 14 und 24 verbunden. Außerdem steuert der Ausgang 6 des Impulsgenerators 3 den Dreieckgenerator 4 so, daß die Grundfrequenz der von diesem erzeugten Dreieckspannung $U_1$ gleich der Frequenz $f_B$ ist. Der Ausgang des UND-Tores 12 bzw. 22 liefert Impulspakete $S_{2u}$ bzw. $S_{2i}$ und ist an den Zähleingang Z des Impulszählers 13 bzw. 23 sowie an den Zähleingang Z des Impulszählers 14 und 24 angeschlossen.

Vom Impulszähler 13 bzw. 23 führt ein Datenbus 17 bzw. 27 zum Differenzglied 16 bzw. 26. Ferner führt ein Datenbus 18 bzw. 28 — gegebenenfalls über das nicht unbedingt erforderliche Glättungsfilter 15 bzw. 25 — zum Differenzglied 16 bzw. 26. Ein Datenbus 19 bzw. 29 verbindet das Differenzglied 16 bzw. 26 mit einem Rechenglied 30, an das ein Impulszähler 31 angeschlossen sein kann. Vorteilhaft sind die Glättungsfilter 15, 25, die Differenzglieder 16, 26 und das Rechenglied 30 durch einen Mikrocomputer 32 gebildet.

Aus der Fig. 2 ist die Entstehung der Impulsfolge $S_{1u}$ und der Impulspakete $S_{2u}$ erkennbar. Die Fig. 2a zeigt einen beispielsweisen Verlauf des Signals u(t), das die zur Nullachse symmetrische Dreieckspannung $U_1$ in den Punkten $P_1$ bis $P_4$ schneidet. In jedem dieser Schnittpunkte wechselt die vom Komparator 11 abgegebene Impulsfolge $S_{1u}$ (Fig. 2b) ihren logischen Zustand.

Es gilt

$$\frac{T_1 - T_2}{T_1 + T_2} = k \cdot u$$

wobei $T_1$ die Impulsdauer und $T_2$ die Pausendauer der Impulsfolge $S_{1u}$ bedeutet. Während der Impulsdauer $T_1$ läßt das UND-Tor 12 die vom Impulsgenerator 3 erzeugten Abtastimpulse durch, so daß vom UND-Tor 12 Impulspakete $S_{2u}$ (Fig. 2c) abgegeben werden, die sich mit der Frequenz $f_b$ wiederholen, wobei die Anzahl Impulse innerhalb eines Paketes ein Maß für den Momentanwert des Signals u(t) darstellt. Während jeder Periode der Frequenz $f_b$ zählt der Impulszähler 13 diese Anzahl und wird danach durch einen Rückstellimpuls an seinem Rückstelleingang R zurückgestellt. Kurz vor der Rückstellung wird der Zählerinhalt des Impulszählers über den Datenbus 17 zum Differenzglied 16 übertragen. Dieser Zählerinhalt stellt einen digitalen Meßwert $M_u$ für den Momentanwert des Signals u(t) und somit für die Spannung des Wechselstromnetzes dar.

Der Impulszähler 14 ermittelt den Mittelwert $M_{mu}$ der Impulsfolge $S_{1u}$ über $N \geq 1$ Netzperioden, wobei N eine ganze Zahl ist. Hierzu werden die Impulse der Impulspakete $S_{2u}$ laufend in den Impulszähler 14 eingezählt. Nach jeweils N Netzperioden wird der Impulszähler 14 durch einen Rückstellimpuls der Frequenz $f_c$ zurückgestellt und neu gestartet. Während jeder Summierdauer T

$$T = \frac{1}{f_c} = N \cdot \frac{1}{f_N}$$

($f_N$ = Netzfrequenz) summiert der Impulszähler 14 jeweils n Spannungs-Meßwerte $M_u$, bildet also die Summe

$$\sum_{i=1}^{n} M_u$$

wobei

$$n = \frac{f_b}{f_c} = N \cdot \frac{f_b}{f_N}$$

ist. Für den Mittelwert $M_{mu}$ der Spannungs-Meßwerte $M_u$ gilt

$$M_{mu} = \frac{1}{n} \sum_{i=1}^{n} M_u$$

Vor jeder Rückstellung des Impulszählers 14 wird der Mittelwert $M_{mu}$ über den Datenbus 18 und gegebenenfalls das Glättungsfilter 15 zum Differenzglied 16 übertragen. Die zur Bildung des Mittelwertes $M_{mu}$ erforderliche Division des Zählerinhaltes des Impulszählers 14 durch n kann durch geeignete Auslesung des Zählerinhaltes erfolgen, was weiter unten noch ausführlicher erläutert wird.

Die vorstehenden Erläuterungen der Arbeitsweise des Spannungsmeßkanals 1 gelten in analoger Weise auch für den Strommeßkanal 2. Am Ende jeder Periode der Frequenz $f_b$ wird der Zählerinhalt des Impulszählers 23, welcher der Impulsdauer der Impulsfolge $S_{1i}$ entspricht und einen digitalen Meßwert $M_i$ für den Strom darstellt, über den Datenbus 27 zum Differenzglied 26 übertragen. Ferner wird am Ende jeder Periode der Frequenz $f_c$ der Mittelwert $M_{mi}$ der Meßwerte $M_i$ über den Datenbus 28 zum Differenzglied 26 übertragen.

Das Differenzglied 16 bildet jeweils beim Eintreffen eines neuen Meßwertes $M_u$ die Differenz $M_u - M_{mu}$ aus diesem Meßwert und dem jeweils anstehenden Mittelwert $M_{mu}$. Entsprechend bildet das Differenzglied 26 die Differenz $M_i - M_{mi}$. Die so korrigierten Meßwerte werden im Rechenglied 30 miteinander multipliziert. Das Ergebnis der Multiplikation entspricht dem Momentanwert der Leistung. Aus den mit der Frequenz $f_b$ anfallenden Momentanwerten der Leistung kann auf bekannte Weise der Mittelwert der Leistung über eine Netzperiode ermittelt und durch Integration im Impulszähler 31 die elektrische Energie gemessen werden.

Zur Vertiefung des Verständnisses der Arbeitsweise der beschriebenen Meßeinrichtung wird noch ein Zahlenbeispiel betrachtet.

Es sei

$$f_N = 50 \text{ Hz}$$
$$f_a = 2^{22} \text{ Hz}$$
$$f_b = 2^{10} \text{ Hz} = 1024 \text{ Hz}$$
$$f_c = 2 \text{ Hz}$$

und somit

$$n = 512 = 2^9$$
$$N = 25$$

Bei diesem Beispiel werden also die Mittelwerte über jeweils 25 Netzperioden gebildet. Die Mittelwertbildung erfaßt jeweils 512 Meßwerte $M_u$ bzw. $M_i$. Da die Frequenzen $f_a$ und $f_b$ kein ganzzahliges Vielfaches der Netzfrequenz $f_N$ sind, wird der durch die endliche Abtastfrequenz prinzipbedingte Meßfehler über mehrere Meßperioden kompensiert. Die Division des Zählerstandes der Impulszähler 14 und 24 durch die Zahl $n = 2^9$ kann auf einfache Weise durch eine Schiebeoperation um 9 Bits erfolgen, indem beim Auslesen des Zählerstandes die 9 niederwertigsten Bits unbeachtet gelassen werden.

Bei $T_1 = T_2$ werden jeweils 2048, bei $T_1 = 0$ jeweils Null und bei $T_2 = 0$ jeweils 4096 Impulse in die Impulszähler 13 und 23 eingezählt. Diese Impulszähler stellen also die Spannung bzw. den Strom (vorausgesetzt, daß die Komparatoren 11, 21 bis an die Grenze ausgesteuert werden, was vermieden werden soll) durch Zahlenwerte zwischen 0 und 4096 dar, d. h. die Nullinie ist um die Zahl 2048 verschoben. Der Mittelwert $M_{mu}$ bzw. $M_{mi}$ schwankt ebenfalls um den Zahlenwert 2048, so daß die vom Differenzglied 16 bzw. 26 gebildete Differenz je nach Größe und Vorzeichen der Signale u(t) bzw. i(t) Zahlenwerte zwischen $-2048$ und $+2048$ annimmt.

Die Vorteile der beschriebenen Meßeinrichtung lassen sich nun leicht erkennen. Der Mittelwert einer reinen Wechselstromgröße über eine oder mehrere Netzperioden ist bekanntlich Null. Die Abweichung der von den Impulszählern 14 und 24 erfaßten Mittelwerte von Null (bzw. die Abweichung vom Zahlenwert 2048 beim beschriebenen Ausführungsbeispiel) ist gleich dem mittleren Meßfehler, der durch Offsetspannungen, Offsetströme, Unsymmetrien u. dgl. der an der Messung beteiligten Bauelemente oder durch Gleichspannungen und Gleichströme im Wechselstromnetz auftreten kann, so daß der Meßfehler theoretisch vollständig korrigiert wird. Infolge der unvermeidbaren Schwankungen der Netzfrequenz und der nicht beliebig hohen Abtastfrequenz kann in der Praxis der Mittelwert nicht fehlerfrei, aber doch mit genügender Genauigkeit ermittelt werden. Eine weitere Steigerung der Meßgenauigkeit ergibt sich durch die Glättungsfilter 15 und 25, die bekannte, nach einem Glättungsalgorhythmus arbeitende Mittelwert- oder Exponentialfilter sein können. Der Glättungsalgorhythmus zur Glättung der Mittelwerte kann in einem Speicher des Mikrocomputers 32 gespeichert sein.

Bei weniger hohen Anforderungen an die Meßgenauigkeit kann es genügen, die beschriebene Ermittlung des Mittelwertes und Bildung der Differenz aus dem Meßwert und dem Mittelwert nur in einem der beiden Meßkanäle 1, 2 vorzunehmen, da ein Symmetriefehler nur einen Beitrag an das im Rechenglied 30 gebildete Produkt liefern kann, wenn er in beiden Meßkanälen auftritt.

**Patentansprüche**

1. Einrichtung zur Messung elektrischer Leistung in einem Wechselstromnetz, insbesondere für einen statischen Elektrizitätszähler, mit einem ersten und einem zweiten Modulator (11, 4 bzw. 21, 4) zur Bildung einer ersten bzw. einer zweiten Impulsfolge ($S_{1u}$ bzw. $S_{1i}$), deren Impulsdauer ($T_1$) ein Maß für den Momentanwert (u bzw. i) der Spannung bzw. des Stromes darstellt, mit einem Impulsgenerator (3) zur Erzeugung von Abtastimpulsen, mit einem vom ersten Modulator (11, 4) und vom Impulsgenerator (3) gesteuerten ersten Impulszähler (13) zur Ermittlung von der Impulsdauer ($T_1$) der ersten Impulsfolge ($S_{1u}$) entsprechenden digitalen Spannungs-Meßwerten ($M_u$), mit einem vom zweiten Modulator (21, 4) und vom Impulsgenerator (3) gesteuerten zweiten Impulszähler (23) zur Ermittlung von der Impulsdauer der zweiten Impulsfolge ($S_{1i}$) entsprechenden digitalen Strom-Meßwerten ($M_i$) und mit einem Rechenglied (30) zur Bildung des Produktes aus den Momentanwerten (u bzw. i) der Spannung und des Stromes, gekennzeichnet durch mindestens einen digitalen Mittelwertbilder (14; 24) zur Ermittlung des Mittelwertes ($M_{mu}$; $M_{mi}$) der Impulsdauer ($T_1$) der ersten bzw. der zweiten Impulsfolge ($S_{1u}$; $S_{1i}$) über eine oder mehrere Netzperioden und durch mindestens ein digitales Differenzglied (16; 26) zur Ermittlung der Differenz aus den Spannungs-Meßwerten ($M_u$) bzw. den Strom-Meßwerten ($M_i$) und aus dem zugehörigen Mittelwert ($M_{mu}$; $M_{mi}$) der Impulsdauer ($T_1$) der ersten bzw. der zweiten Impulsfolge ($S_{1u}$; $S_{1i}$), wobei die Differenz dem Rechenglied als Spannungs- bzw. Strommomentanwert zugeführt wird.

2. Einrichtung nach Anspruch 1, dadurch gekennzeichnet, daß der Mittelwertbilder (14; 24) ein vom ersten bzw. vom zweiten Modulator (11, 4; 21, 4) und vom Impulsgenerator (3) gesteuerter weiterer Impulszähler ist.

3. Einrichtung nach Anspruch 1 oder 2, dadurch gekennzeichnet, daß im Datenbus (18; 28) zwischen dem Mittelwertbilder (14; 24) und dem Differenzglied (16; 26) ein Glättungsfilter (15; 25) angeordnet ist.

4. Einrichtung nach Anspruch 3, dadurch gekennzeichnet, daß das Glättungsfilter (15; 25), das Differenzglied (16; 26) und das Rechenglied (30) durch einen Mikrocomputer (32) gebildet sind und daß in einem Speicher des Mikrocomputers (32) ein Glättungsalgorythmus zur Glättung der vom Mittelwertbilder (14; 24) ermittelten Mittelwerte ($M_{mu}$; $M_{mi}$) gespeichert ist.

5. Einrichtung nach einem der Ansprüche 2 bis 4, dadurch gekennzeichnet, daß der Impulsgenerator (3) drei Ausgänge (5; 6; 7) aufweist, dessen erster Ausgang (5) mit einem an den ersten Modulator (11; 4) angeschlossenen ersten UND-Tor (12) und mit einem an den zweiten Modulator (21, 4) angeschlossenen zweiten UND-Tor (22), dessen zweiter Ausgang (6) mit je einem Rückstelleingang (R) des ersten und des zweiten Impulszählers (13; 23) und dessen dritter Ausgang (7) mit einem Rückstelleingang (R) des weiteren Impulszählers (14; 24) verbunden ist, daß der Ausgang des ersten bzw. des zweiten UND-Tores (12; 22) an den Zähleingang (Z) des ersten bzw. des zweiten Impulszählers (13; 23) und an den Zähleingang (Z) des weiteren Impulszählers (14; 24) angeschlossen ist, daß der zweite Ausgang (6) des Impulsgenerators (3) die Frequenz des ersten und des zweiten Modulators (11, 4; 21, 4) steuert, daß die Frequenz ($f_b$) am zweiten Ausgang (6) des Impulsgenerators (3) ein Vielfaches der Frequenz ($f_c$) am dritten Ausgang (7) beträgt und daß die Frequenz ($f_a$) am ersten Ausgang (5) des Impulsgenerators (3) ein Vielfaches der Frequenz ($f_b$) am zweiten Ausgang (6) beträgt.

## Claims

1. Apparatus for measuring electrical power in an alternating current mains, in particular for a static electricity meter, having a first and a second modulator (11, 4 and 21, 4 respectively) for respectively forming a first and a second pulse series ($S_{1u}$ and $S_{1i}$), the pulse duration ($T_1$) of which represents a measurement in respect of the instantaneous value (u or i) of the voltage or current, a pulse generator (3) for producing scanning pulses, a first pulse counter (13) which is controlled by the first modulator (11, 4) an by the pulse generator (3), for determining digital voltage measurement values ($M_u$) corresponding to the pulse duration ($T_1$) of the first pulse series ($S_{1u}$), a second pulse counter (23) controlled by the second modulator (21, 4) and by the pulse generator (3) for determining digital current measurement values ($M_i$) corresponding to the pulse duration of the second pulse series ($S_{1i}$), and a computing means (30) for forming the product of the instantaneous values (u and i) of the voltage and the current, characterised by at least one digital mean value-forming means (14; 24) for determining the mean value ($M_{mu}$; $M_{mi}$) of the pulse duration ($T_1$) of the first and the second pulse series ($S_{1u}$; $A_{1i}$) respectively, over one or more mains periods, and by at least one digital differencing means (16; 26) for determining the difference of the voltage measurement values ($M_u$) and the current measurement values ($M_i$) respectively and the associated mean value ($M_{mu}$; $M_{mi}$) of the pulse duration ($T_1$) of the first and second pulse series ($S_{1u}$; $S_{1i}$), wherein the difference is supplied to the computing means as voltage and current instantaneous values respectively.

2. Apparatus according to claim 1 characterised in that the mean value-forming means (14; 24) is a further pulse counter which is controlled by the first and the second modulator (11, 4; 21, 4) respectively and by the pulse generator (3).

3. Apparatus according to claim 1 or claim 2, characterised in that a smoothing filter (15; 25) is arranged in the data bus (18; 28) between the mean value-forming means (14; 24) and the differencing means (16; 26).

4. Apparatus according to claim 3 characterised in that the smoothing Filter (15; 25), the differencing means (16; 26) and the computing means (30) are formed by a microcomputer (32) and that a smoothing algorithm is stored in a memory of the microcomputer (32), for smoothing the mean values ($M_{mu}$; $M_{mi}$) determined by the mean value-forming means (14; 24).

5. Apparatus according to one of claims 2 to 4, characterised in that the pulse generator (3) has three outputs (5; 6; 7), of which the first output (5) is connected to a first AND-gate (12) connected to the first modulator (11; 4) and a second AND-gate (22) connected to the second modulator (21, 4), a second output (6) is connected to a reset input (R) of each of the first and second pulse counters (13; 23) and a third output (7) is connected to a reset input (R) of the further pulse counter (14; 24), that the outputs of the first and second AND-gates (12; 22) are connected to the counting inputs (Z) of the first and second pulse counters (13; 23) respectively and to the counting input (Z) of the further pulse counter (14; 24), that the second output (6) of the pulse generator (3) controls the frequency of the first and the second modulators (11, 4; 21, 4), that the frequency ($f_b$) at the second output (6) of the pulse generator (3) is a multiple of the frequency ($f_c$) at the third output (7) and that the frequency ($f_a$) at the first output (5) of the pulse generator (3) is a multiple of the frequency ($f_b$) at the second output (6).

## Revendications

1. Dispositif pour la mesure d'énergie électrique dans un réseau à courant alternatif, en particulier pour un compteur électrique statique, comportant des premier et second modulateurs (11, 4 et 21, 4) pour la formation de premier et second trains d'impulsions ($S_{1u}$ et $S_{1i}$), dont la durée d'impulsions ($T_1$) représente une mesure de la valeur instantanée (u et i) de la tension et du courant, un générateur d'impulsions (3), pour la génération d'impulsions d'échantillonnage, un premier modulateur (11, 4) et par le générateur d'impulsions (3) pour la détermination de valeurs de tension mesurées numériques ($M_u$) corrspondant à la durée des impulsions ($T_1$) du premier train d'impulsions ($S_u$), un second compteur d'impulsions (23) commendé par le second modulator (21, 4) et par le générateur d'impulsions (3) pour la détermination de valeurs de courant mesurées numériques ($M_i$) corrspondant à la durée des impulsions du second train d'impulsions ($S_{1i}$), et un élément de calcul (30) pour la formation du produit des valeurs instantanées (u et i) de la tension et du courant, ledit dispositif étant caractérisé par au moins un élément numérique de formation de valeur moyenne (14; 24) pour la détermination de la valeur moyenne ($M_{mu}$; $M_{mi}$) des durées des impulsions ($T_1$) des premier respectivement second trains d'impulsions ($S_{1u}$; $S_{1i}$) sur une ou plusieurs périodes de réseau, et par au moins un élément numérique de formation de différence (16; 26) pour la détermination de la différence entre les valeurs de tension mesurées ($M_u$) ou les valeurs de courant mesurées ($M_i$) et la valeur moyenne correspondante ($M_{mu}$; $M_{mi}$) des durées

des impulsions ($T_1$) des premier ou second trains d'impulsions ($S_{1u}$; $S_{1i}$), ladite différence étant transmise à l'élément de calcul en tant que valeur instantanée de tension ou de courant.

2. Dispositif suivant la revendication 1, caractérisé en ce que l'élément de formation de valeur moyenne (14; 24) est constitué par un autre compteur d'impulsions commandé par les premier ou second modulateurs (11, 4; 21, 4) et par le générateur d'impulsions (3).

3. Dispositif suivant la revendication 1 ou la revendication 2, caractérisé en ce que dans le bus de données (18; 28), entre l'élément de formation de valeur moyenne (14; 24) et l'élément de formation de différence (16; 26) est disposé un filtre de lissage (15; 25).

4. Dispositif suivant la revendication 3, caractérisé en ce que le filtre de lissage (15; 25), l'élément de formation de différence (16; 26) et l'élément de calcul (30) sont constitués par un micro-ordinateurs (32), et en ce que, dans une mémoire du micro-ordinateur (32) est stocké un algorithme de lissage pour le lissage des valeurs moyenne ($M_{mu}$; $M_{mi}$) déterminées par les éléments de formation de valeur moyenne (14; 24).

5. Dispositif suivant l'une des revendications 2 à 4, caractérisé en ce que le générateur d'impulsions (3) présente trois sorties (5; 6; 7), dont la première sortie (5) est reliée à une première porte ET (12) connectée au premier modulateur (11; 4) et à une seconde porte ET (22) connectée au second modulateur (21; 4), dont la deuxième sortie (6) est reliée aux entrées de remise à zéro respectives (R) des premier et second compteurs d'impulsions (13; 23) et dont la troisième sortie (7) est reliée à l'entrée de remise à zéro (R) de l'autre compteur d'impulsions précité (14; 24), en ce que les sorties respectives des première et seconde portes ET (12; 22) sont connectées aux entrées de comptage respectives (Z) des premier et second compteurs d'impulsions (13; 23) et à l'entrée de comptage (Z) dudit autre compteur d'impulsions (14; 24), en ce que la deuxième sortie (6) du générateur d'impulsions (3) commande la fréquence des premier et second modulateurs (11, 4; 21, 4), en ce que la fréquence ($f_b$) apparaissant à la deuxième sortie (6) du générateur d'impulsions (3) est un multiple de la fréquence ($f_c$) apparaissant à la troisième sortie (7), et en ce que la fréquence ($f_a$) apparaissant à la première sortie (5) du générateur d'impulsions (3) est un multiple de la fréquence ($f_b$) apparaissant à la deuxième sortie (6).

# Fig. 1

# Fig. 2a

# Fig. 2b

# Fig. 2c